# EUROPÄISCHE PATENTSCHRIFT

(11) **EP 3 524 992 B1**
(45) Veröffentlichungstag und Bekanntmachung des Hinweises auf die Patenterteilung: **07.04.2021**
(21) Anmeldenummer: 18156516.9
(22) Anmeldetag: 13.02.2018
(51) Int. Cl.: G01R 33/28, G01R 33/561, G01R 33/483

(54) **VERFAHREN ZUM BETRIEB EINER MAGNETRESONANZEINRICHTUNG, MAGNETRESONANZEINRICHTUNG, COMPUTERPROGRAMM UND ELEKTRONISCH LESBARER DATENTRÄGER**
METHOD FOR OPERATING A MAGNETIC RESONANCE DEVICE, MAGNETIC RESONANCE DEVICE, COMPUTER PROGRAM AND ELECTRONICALLY READABLE DATA CARRIER
PROCÉDÉ DE FONCTIONNEMENT D'UN DISPOSITIF DE RÉSONANCE MAGNÉTIQUE, DISPOSITIF DE RÉSONANCE MAGNÉTIQUE, PROGRAMME INFORMATIQUE ET SUPPORT DE DONNÉES ÉLECTRONIQUEMENT LISIBLE

(43) Veröffentlichungstag der Anmeldung: 14.08.2019
(73) Patentinhaber: Siemens Healthcare GmbH, 91052 Erlangen (DE)
(72) Erfinder: Zeller, Mario, 91054 Erlangen (DE)

(56) Entgegenhaltungen:
- US-A1- 2015 369 891
- US-A1- 2017 315 202
- US-A1- 2018 031 659

## Beschreibung

Verfahren zum Betrieb einer Magnetresonanzeinrichtung, Magnetresonanzeinrichtung, Computerprogramm und elektronisch lesbarer Datenträger

Die Erfindung betrifft ein Verfahren zum Betrieb einer Magnetresonanzeinrichtung bei der Aufnahme von Magnetresonanzdaten eines Patienten mit einer Magnetresonanzsequenz, die nach wenigstens einem Anregungspuls mehrere Refokussierungspulse während eines Auslesezeitraums umfasst, wobei die Stärke der Refokussierungspulse einem zeitlichen Flipwinkelverlauf folgt, der die spezifische Absorptionsrate (SAR) für den Patienten minimierend bestimmt wird. Daneben betrifft die Erfindung eine Magnetresonanzeinrichtung, ein Computerprogramm und einen elektronisch lesbaren Datenträger.

Die Magnetresonanzbildgebung ist inzwischen eine etablierte Bildgebungsmodalität, insbesondere im medizinischen Bereich. Durch Anregung von in einem Grundmagnetfeld ausgerichteten Kernspins eines Patienten in einem Aufnahmebereich, beispielsweise wenigstens einer Schicht, mittels Hochfrequenz-Anregungssignalen werden zu einem späteren Zeitpunkt aufzunehmende Magnetresonanzsignale erzeugt, die mittels entsprechender Hochfrequenzspulen empfangen und zu Magnetresonanzdaten gewandelt werden können. Durch die Anregungspulse sowie weitere, im Lauf einer Magnetresonanzsequenz verwendete Hochfrequenzpulse wird elektromagnetische Energie in den Körper des Patienten eingebracht, so dass die SAR-Belastung ein wichtiges Thema bei der Entwicklung neuer Bildgebungstechniken darstellt. Ein weiterer Aspekt aktueller Forschungen ist die Beschleunigung der Bildgebung an sich, um den Patientendurchsatz zu erhöhen und die Bildgebung für den Patienten angenehmer zu gestalten.

Bereits vorgeschlagene beschleunigende Bildgebungstechniken umfassen auch die simultane Mehrschichtbildgebung (SMS - simultaneous multislice), bei der innerhalb einer Repetition mehrere Schichten gleichzeitig angeregt werden und gleichzeitig ausgelesen werden. Ein beispielhaftes konkretes Mehrschichtbildgebungsverfahren ist unter dem Namen "CAIPI" (Controlled Aliasing in Parallel Imaging) bekannt, vgl. hierzu beispielsweise den Artikel von K. Setsompop et al., "Blipped-Controlled Aliasing in Parallel Imaging for Simultaneous Multislice Echo Planar Imaging With Reduced g-Factor Penalty", Magnetic Resonance in Medicine 67: 1210-1224 (2012).

Zur simultanen Anregung mehrerer Schichten kann ein sogenannter Mehrband-Anregungspuls verwendet werden. Für jede Schicht, die angeregt werden soll, wird eine lineare Phasenrampe zum Standard-Anregungspuls hinzugefügt. Diese lineare Phase führt zu einer Schichtverschiebung in der räumlichen Domäne. Schließlich werden die Pulsformen für alle Schichten, also Bänder, addiert, so dass ein Basisband-modulierter Mehrband-Anregungspuls resultiert. Um die g-Faktor-Nachteile zu verringern, werden Bildverschiebungen zwischen den Schichten während des Auslesezeitraums induziert, indem entweder Gradienten-Blips auf der Schichtachse verwendet werden oder die Phase der Hochfrequenzpulse moduliert wird. Nach der Aufnahme liegen Magnetresonanzdaten aller simultan angeregter Schichten als eine Art "einzige Schicht" vor. Die Magnetresonanzdaten der Einzelschichten können hieraus, beispielsweise unter Verwendung eines Schicht-GRAPPA-Algorithmus, extrahiert werden.

Eine allgemein in der klinischen Magnetresonanzbildgebung häufig eingesetzte Magnetresonanzsequenz, die ebenso als beschleunigende Bildgebungstechnik verstanden werden kann, ist die Turbo-Spinecho-Sequenz (TSE-Sequenz). Diese besteht aus mehreren Echozügen, wobei in jedem Echozug mehrere k-RaumLinien in Phasenkodierungsrichtung nach einem einzigen Anregungspuls aufgenommen werden. Dies wird erreicht, in dem die angeregten Kernspins nach dem Auslesen jeder k-Raumlinie mittels eines Refokussierungspulses refokussiert werden, um ein weiteres Echo zu erzeugen. Im Vergleich zu herkömmlichen Spinecho-Sequenz wird die Aufnahmezeit um die Zahl der refokussierten Echos in einem einzigen Echozug reduziert (Turbo-Faktor) .

Es wurde auch bereits vorgeschlagen, Mehrschichtbildgebung (SMS) und TSE-Sequenzen zu kombinieren, um zwei oder mehr Schichten gleichzeitig aufnehmen zu können. Während man unter der (effektiven) Echozeit TE die Zeit zwischen dem Anregungspuls und der Aufnahme (Abtastung) des Magnetresonanzsignals des k-Raumzentrums versteht, ist die Repetitionszeit TR als die Zeit zwischen zwei aufeinander folgenden Anregungspulsen definiert. Bei der Kombination von SMS und TSE hat sich nun gezeigt, dass die minimale Repetitionszeit reduziert werden kann, nachdem weniger Schichten aufgenommen werden müssen. Dabei ist jedoch zu beachten, dass die minimale Repetitionszeit letztlich häufig nicht durch die Gesamtzeit aller Echozüge limitiert wird, sondern durch den gewollten Bildkontrast. Beispielsweise ist für die T2-gewichtete Bildgebung eine lange Repetitionszeit notwendig, so dass die T1-Relaxation den gewollten T2-Kontrast bereitstellt. Das bedeutet, dass bei einer Repetitionszeit von 5 Sekunden ohne Mehrschichtbildgebung und einem SMS-Faktor von 2 (gleichzeitige Aufnahme von zwei Schichten) eine Repetitionszeit von 2,5 Sekunden grundsätzlich möglich wäre, diese niedrige Repetitionszeit jedoch nicht erreicht werden kann, ohne dass der Bildkontrast derart verändert wird, dass das Bildgebungsergebnis klinisch nicht mehr akzeptabel ist.

Auch bei der Anwendung von simultaner Mehrschichtbildgebung auf die FLAIR-T2-gewichtete TSE-Sequenz (FLAIR - Fluid Attenuated Inversion Recovery) können Probleme auftreten. Die FLAIR-T2-gewichtete TSE-Sequenz liefert einen T2-gewichteten Kontrast bei unterdrückten Magnetresonanzsignalen von den cerebrosspinalen Fluiden (CSF), wobei die entsprechende Signalunterdrückung durch vorangehende Inversionspulse als Präparationspulse und eine relativ lange Wartezeit (Inversionszeit) von 2,5 Sekunden zwischen den Präparationspulsen und dem Auslesemodul erreicht wird. Dabei werden die Echozüge für zwei benachbarte, aufzunehmende Schichten üblicherweise in zwei unterschiedlichen Aufnahmeabschnitten (concatenations) ausgespielt, um Störeffekte der benachbarten Schichten (cross talk) zu vermeiden. Mittels der Mehrschichtbildgebung wäre es theoretisch möglich, die Zahl der Aufnahmeabschnitte (concatenations) zu reduzieren, wobei dies in der Praxis wiederum zu Crosstalk zwischen Schichten führen würde. Ein anderer Nachteil ist, dass der Präparationspuls gegebenenfalls nicht für mehrere Schichten gleichzeitig realisiert werden kann, da Spitzenleistungsbeschränkungen existieren (zwei Präparationspulse für jeweils eine einzige Schicht, die zu einem Multiband-Präparationspuls zusammengefasst werden, führen zur doppelten Spitzenleistung).

Mit steigenden Grundfeldstärken, insbesondere von größer als 3 T, und größerer Abdeckung durch die aufzunehmenden Schichten stellen SAR-Belastungen eine andere große Herausforderung dar, wenn die Mehrschichtbildgebungstechnik mit herkömmlichen Aufnahmetechniken kombiniert werden soll, nachdem der Anstieg der Spitzenleistung ein Vielfaches des SMS-Faktors, also der Zahl der gleichzeitig aufzunehmenden Schichten, ist. Im Allgemeinen ist die SAR proportional zum Quadrat des Flipwinkels.

Auf der anderen Seite umfassen typische Magnetresonanzuntersuchungen häufig die Verwendung mehrerer TSE-Sequenzen mit unterschiedlichen Kontrasten. Beispielsweise umfasst eine typische Aufnahme im Kopfbereich eines Patienten sowohl die übliche T2-gewichtete TSE-Bildgebung und eine FLAIR-T2-gewichtete TSE-Bildgebung. Andere Kombinationen von Sequenzen mit und ohne Präparationspulse lassen sich auf andere Körperregionen anwenden, beispielsweise Protonendichte(PD)/T1/T2 und Protonendichte-STIR, T1-STIR, T2-STIR oder Protonendichte und T1-FLAIR.

Im Hinblick auf solche häufig auftretenden Konstellationen, in denen auf unterschiedliche Kontraste abzielende Magnetresonanzsequenzen verwendet werden, die teils mit, teils ohne Präparationspulse durchgeführt werden sollen, wurde in US 2017/0108567 A1 eine Mehrkontrast-SMS-Bildgebungsvariante vorgeschlagen. Konkret soll hierbei der wenigstens eine Präparationspuls nur auf eine der gleichzeitig aufgenommenen Schichten angewendet werden, so dass ein Mehrkontrast-Datensatz mit den Präparationspuls-manipulierten Kontrasten für die eine Schicht und einer konventionellen Gewichtung für die zweite Schicht entsteht. In einer zweiten Repetition wird die Anregungsreihenfolge umgedreht, das bedeutet, der Präparationspuls wirkt dann auf die zweite Schicht, während für die erste Schicht die konventionell gewichteten Magnetresonanzdaten entstehen. Auf diese Weise ist eine bessere Nutzung von Totzeiten möglich und Spitzenleistungs-Probleme mit den Präparationspulsen, die üblicherweise Hochleistungspulse sind, werden vermieden.

Ein anderes Problem hinsichtlich der Spitzenleistung/der SAR stellen jedoch die erwähnten Refokussierungspulse dar, mit Hilfe derer nach einer einzigen Anregung mehrere Echos erzeugt werden sollen, um mehrere k-Raumlinien nach einer einzigen Anregung auslesen zu können. Zur Lösung dieser Probleme wurde im Stand der Technik die sogenannte Hyperecho-Bildgebung vorgeschlagen (vgl. hierzu beispielsweise den Artikel von Jürgen Hennig und Klaus Scheffler, "Hyperechoes", Magnetic Resonance in Medicine 46: 6-12 (2001), welche später als TRAPS (Smooth Transition Between Steady States) verallgemeinert wurde, vgl. hierzu beispielsweise den Artikel von Jürgen Hennig, Matthias Weigel und Klaus Scheffler, "Multiecho Sequences With Variable Refocusing Flip Angles: Optimization of Signal Behavior Using Smooth Transitions Between Pseudo Steady States (TRAPS)", Magnetic Resonance in Medicine 49: 527-535 (2003), und den Artikel von Matthias Weigel, Maxim Zaitsev und Jürgen Hennig, "Inversion Recovery Prepared Turbo Spin Echo Sequences With Reduced SAR Using Smooth Transitions Between Pseudo Steady States", Magnetic Resonance in Medicine 57: 631-637 (2007). Darin wird vorgeschlagen, statt der wiederholten Verwendung von 180°-Refokussierungspulsen den zeitlichen Flipwinkelverlauf über die Anzahl auszugebender Refokussierungnspulse zur Reduzierung der SAR anzupassen. Dabei ist der Flipwinkel des Flipwinkelverlaufs, der sich auf die Zeitpunkte der Ausgabe von Refokussierungspulsen bezieht, als den Refokussierungspuls, konkret seine Stärke, bestimmender Steuerparameter zu verstehen. In Verbindung mit einer kurzen glatten Flipwinkel-Vorbereitungsphase (Präparationsphase) zu Beginn jedes Echozuges kann der Signalverlust im Vergleich zur Anwendung von lediglich 180°-Refokussierungspulsen deutlich reduziert werden. Eine ausführliche Analyse verschiedener TRAPS-Flipwinkelverläufe und der Auswirkungen auf Bildkontraste können der Dissertation von Matthias Weigel, "Entwicklung, Optimierung und klinische Erprobung von T2-gewichteten Messverfahren mit reduzierter Hochfrequenzleistung für die Kernspintomographie", Fakultät für Mathematik und Physik der Albert-Ludwigs-Universität Freiburg im Breisgau, Oktober 2007, entnommen werden. Insbesondere wurde vorgeschlagen, einen geeigneten Flipwinkelverlauf für die Refokussierungspulse im Rahmen eines Optimierungsverfahrens zu gewinnen, dessen erstes, hoch gewichtetes Optimierungskriterium eine Minimierung der SAR-Belastung ist, während ein geringer gewichtetes Optimierungskriterium eine möglichst hohe Signalintensität herstellen soll.

US 2015/0 369 891 A1 betrifft die SAR-Reduzierung in der FASE- oder SS-FSE-Bildgebung. Dort wird vorgeschlagen, die Flipwinkel von Refokussierungspulsen in der Phasenkodierungsrichtung und/oder der Schichtkodierungsrichtung zu variieren, so dass die Refokussierungspulse, die sich auf Echosignale aus dem k-Raumzentrum beziehen, höhere Refokussierungs-Flipwinkel erhalten als außerhalb des k-Raumzentrums Echosignale generierende Refokussierungspulse.

US 2018/0 031 659 A1 ofeenbart ein Verfahren und eine Magnetresonanzeinrichtung zur simultanen Mehrkontrast-TSE-Bildgebung. Dort wird von dem Problem ausgegangen, dass aufgrund der nacheinander erfolgenden Ausführungen der Bildgebungsprotokolle ein Großteil der gesamten Aufnahmezeit nicht für die Bildgebung genutzt werden kann, woran auch SMS-Bildgebung nichts ändern würde, nachdem sich die Totzeit lediglich erhöhen würde. Zur Lösung wird vorgeschlagen, eine gleichzeitige Anregung vorzunehmen, jedoch Magnetresonanzdaten der unterschiedlichen Kontraste in unterschiedlichen Abschnitten des Echozuges aufzunehmen, um so eine verbesserte Ausnutzung der Zeitabläufe zu bieten.

US 2017/0 315 202 A1 betrifft die simultane Mehrschicht-Mehrecho-TSE-Bildgebung, wobei vorgeschlagen wird, die Schichten zu unterschiedlichen Zeitpunkten anzuregen, während der Auslese-Echozug geteilt ist und die einzelnen k-Raumorte gleichzeitig aufgenommen werden. Es sollen unterschiedliche Echozeiten für unterschiedliche Kontraste ausgenutzt werden.

Der Erfindung liegt die Aufgabe zugrunde, eine Möglichkeit zur Reduzierung von Spitzenleistungen und der SAR-Belastung für Patienten in der simultanen Mehrschicht-TSE-Bildgebung anzugeben.

Zur Lösung dieser Aufgabe sind erfindungsgemäß ein Verfahren, eine Magnetresonanzeinrichtung und ein Computerprogramm gemäß den unabhängigen Ansprüchen vorgesehen.

Es wird ein Vorgehen vorgeschlagen, das die Reduzierung der Gesamt-SAR während einer Aufnahme von Magnetresonanzdaten in der simultanen Mehrschichtbildgebung (SMS) erlaubt. Dabei wird grundsätzlich vorgeschlagen, die TRAPS-Methode, wie sie in den eingangs genannten Druckschriften ausführlich beschrieben ist, einzusetzen, jedoch einen weiteren Freiheitsgrad zu nutzen, nämlich den Einsatz unterschiedlicher Flipwinkelverläufe für unterschiedliche, gleichzeitig aufzunehmende Schichten. Auf diese Weise kann insbesondere vermieden werden, dass Maxima der Flipwinkelverläufe jeweils zusammenfallen, so dass Refokussierungspulse besonders hoher Leistung, die somit eine besonders hohe SAR-Belastung mit sich bringen, vermieden werden können. Dabei lässt sich das erfindungsgemäß vorgeschlagene Vorgehen besonders vorteilhaft auf Mehrkontrast-Aufnahmen anwenden, wie sie beispielsweise in der eingangs genannten US 2017/0108567 A1 diskutiert wurden. Dies liegt darin begründet, dass durch die unterschiedlichen Flipwinkelverläufe unterschiedliche Signalintensitäten bei der Aufnahme der Magnetresonanzdaten und somit unterschiedliche Kontrasteigenschaften auftreten können. Diese subtilen Unterschiede beeinflussen die Auswertung der Magnetresonanzdaten deutlich weniger, wenn sie ohnehin zwischen unterschiedlichen gewünschten Bildkontrasten vorliegen, beispielsweise FLAIR-T2-gewichteten TSE-Sequenzen und konventionellen T2-gewichteten TSE-Sequenzen. Nichtsdestotrotz lässt sich das erfindungsgemäße Verfahren auch auf die Standard-SMS-Bildgebung anwenden, bei der also Schichten für denselben Kontrast gleichzeitig aufgenommen werden sollen, obwohl dann kleinere Unterschiede in den Kontrasteigenschaften zwischen Schichten unterschiedlicher Flipwinkelverläufe auftreten können.

Dabei sei an dieser Stelle noch darauf hingewiesen, dass im Rahmen der vorliegenden Erfindung Flipwinkelverläufe auch bereits als unterschiedlich angesehen werden, wenn grundsätzlich gleiche Grundverläufe verwendet werden, die aber zeitlich versetzt sind, worauf im Folgenden noch näher eingegangen werden wird. Ferner beziehen sich die Flipwinkelverläufe, wie bei der TRAPS-Methode üblich, auf Vorgabewerte für die Refokussierungspulse an Zeitpunkten, zu denen ein Refokussierungspuls ausgegeben werden soll (nicht einen tatsächlichen Flipwinkelverlauf der Kernspins).

Das erfindungsgemäße Vorgehen sieht mithin vor, unterschiedliche zeitliche Flipwinkelverläufe für die Refokussierungspulse einzusetzen, um eine reduzierte Spitzenleistung und eine reduzierte SAR in der Mehrschichtbildgebung zu erlauben, insbesondere eine deutliche Verbesserung gegenüber der Verwendung gleicher Flipwinkelschemata für alle gleichzeitig aufzunehmenden Schichten. Dies eröffnet zusätzliche Anwendungsfälle für die Mehrschichtbildgebungstechnik (SMS), erhöht die Schichtabdeckung und erlaubt den Einsatz von Mehrschichtbildgebungstechniken auch bei höheren Grundmagnetfeldstärken, beispielsweise von mehr als 3 T, insbesondere von 7 oder mehr T.

Bei der Magnetresonanzsequenz handelt es sich bevorzugt um eine TSE-Sequenz, bei der sich gezeigt hat, dass die größte Effektivität für Spinecho-Varianten gegeben ist, die üblicherweise äußerst hohe Flipwinkel für die Refokussierungspulse benötigen. Nichtsdestotrotz kann das Verfahren auch auf andere Magnetresonanzsequenzen, die im Rahmen der Mehrschichtbildgebungstechnik angewendet werden können, angewandt werden.

Wie bereits erwähnt, sieht eine besonders bevorzugte Ausgestaltung der vorliegenden Erfindung vor, dass jede aufzunehmende Schicht mit mehreren unterschiedlichen Kontrasten aufgenommen wird, wobei bei der Mehrschichtbildgebungstechnik die unterschiedlichen, gleichzeitig zu vermessenden Schichten jeweils mit einem anderen der Kontraste aufgenommen werden und die Kontraste in folgenden Repetitionen derselben schichten derart permutiert werden, dass jede Schicht mit jedem Kontrast aufgenommen wurde, wobei für jeden Kontrast ein eigener Flipwinkelverlauf bestimmt wird, der für jede Messung mit diesem Kontrast verwendet wird. Auf diese Weise wird letztlich das in US 2017/0108567 A1 beschriebene Vorgehen erweitert, nachdem beispielsweise bei zwei Schichten zunächst die erste Schicht mit dem ersten Kontrast, die zweite Schicht mit dem zweiten Kontrast aufgenommen wird, wonach die erste Schicht mit dem zweiten Kontrast und die zweite Schicht mit dem ersten Kontrast in einem weiteren Aufnahmeabschnitt vermessen wird. Dabei sind die Flipwinkelverläufe den unterschiedlichen gewünschten Kontrasten, beispielsweise konventionell T2-gewichtet und FLAIR-T2-gewichtet, zugeordnet, so dass innerhalb eines Magnetresonanzdatensatzes für einen Kontrast eine Variation von Signalintensitäten und somit Kontrasteigenschaften aufgrund unterschiedlicher Flipwinkelverläufe vermieden wird. Dabei kann insbesondere vorgesehen sein, dass wenigstens einer, jedoch nicht alle, der unterschiedlichen Kontraste durch Ausgabe eines auf die jeweilige Schicht wirkenden Präparationspulses hergestellt wird. Auf diese Weise wird mithin vermieden, Präparationspulse gleichzeitig für alle anzuregenden Schichten auszugeben, so dass auch hier Spitzenleistungen und erhöhte SAR möglichst weitgehend vermieden wird, wie dies in US 2017/0108567 A1 vorgeschlagen wurde. Als Ergänzung zu diesem Vorgehen werden unterschiedliche Flipwinkelverläufe für die Echozüge für die aufzunehmenden Schichten eingesetzt.

In einer besonders vorteilhaften Weiterbildung der vorliegenden Erfindung kann vorgesehen sein, dass zu unterschiedlichen Echozeiten führende Flipwinkelverläufe verwendet werden, wobei die Anregungssignale und somit die Startzeitpunkte der Flipwinkelverläufe für die unterschiedlichen Schichten zeitlich um ein ganzzahliges Vielfaches der Differenz der Echozeiten versetzt ausgegeben werden, so dass die Echozeiten zum selben Zeitpunkt während der Magnetresonanzsequenz erreicht werden. Dem liegt die Erkenntnis zugrunde, dass Flipwinkel, die kleiner als 180° sind, zu einer teilweisen Speicherung der M_{xy}-Magnetisierung entlang der z-Achse führen, so dass der T2-Zerfall verlängert wird und die Echozeit erhöht werden muss, um einen Kontrast zu erreichen, der vergleichbar zu Magnetresonanzsequenzen mit 180°-Flipwinkeln der Refokussierungspulse ist. Die Erhöhung der Echozeit hängt dabei von dem eingesetzten Flipwinkelverlauf ab. Mithin wird vorgeschlagen, die Echozüge, konkret die Ausgabe der Refokussierungspulse, für die gleichzeitig aufzunehmenden Schichten in der Zeit gegeneinander zu verschieben, um den Überlapp von Refokussierungspulsen mit hohen Flipwinkeln möglichst weitgehend zu vermeiden.

Ein entsprechendes, konkretes Vorgehen wurde für einen anderen Anwendungsfall bereits in US 2017/0315202 A1 vorgeschlagen. Dort geht es um die simultane Mehrschicht-TSE-Bildgebung, wobei aufgrund unterschiedlicher gewünschter Kontraste für alle aufzunehmenden Schichten unterschiedliche Echozeiten vorliegen und dennoch die Auslesezeiträume für die gleichzeitig aufzunehmenden Schichten zusammengeführt werden sollen. Dieses Vorgehen lässt sich mithin auch im Rahmen der vorliegenden Erfindung einsetzen, wobei im Rahmen der vorliegenden Erfindung die Verschiebung der Echozeiten durch die hier erst vorgeschlagenen, unterschiedlichen zeitlichen Flipwinkelverläufe auftritt bzw. modifiziert wird. Durch den Einsatz unterschiedlicher Flipwinkelverläufe, mithin unterschiedliche TRAPS-Schemata für alle aufzunehmenden Schichten, insbesondere zwei Schichten, unterscheiden sich die effektiven Echozeiten beider Schichten. Durch Verschiebung der Anregungspulse gegeneinander und mithin des Startzeitpunkts der Refokussierungspulse können identische Zeitpunkte, zu denen die Echozeit erreicht wird, für beide Schichten erreicht werden. Gleichzeitig wird der Überlapp von Refokussierungspulsen mit hohen Flipwinkeln für die aufzunehmenden Schichten deutlich reduziert.

In einer konkreten Ausgestaltung kann dabei vorgesehen sein, dass gleiche Grundverläufe für die Flipwinkelverläufe verwendet werden, deren Maxima aufgrund der unterschiedlichen Startzeitpunkte gegeneinander versetzt sind. Beispielsweise kann der Grundverlauf durch Einzeloptimierung, wie beispielsweise in der genannten Dissertation von Matthias Weigel beschrieben, ermittelt werden, woraufhin ein beispielsweise durch die Differenz der Echozeiten oder ein Vielfaches hiervon bestimmter Versatz gewählt wird, so dass die Grundverläufe zu verschiedenen Startzeitpunkten beginnen und somit verschiedene Flipwinkelverläufe darstellen, deren Maxima möglichst nicht zusammenfallen.

In einer anderen beispielhaften Variante der vorliegenden Erfindung kann vorgesehen sein, dass für den Flipwinkelverlauf mit dem späteren Startzeitpunkt ein konstanter erster Flipwinkelwert, insbesondere 180°, gewählt wird, während der Flipwinkelverlauf mit dem früheren Startzeitpunkt von einem Startwert, insbesondere 180°, auf einen insbesondere niedriger als der erste Flipwinkelwert gewählten, zweiten Flipwinkelwert abfällt, insbesondere den zweiten Flipwinkelwert bis zum Startzeitpunkt des zweiten Flipwinkelverlaufs erreichend. Wie sich bei der Erforschung der TRAPS-Methode gezeigt hat, ist es zweckmäßig, für die ersten Refokussierungspulse (TRAPS-Präparationsphase) relativ hohe Flipwinkel zu verwenden. Hier zeigt sich bereits die Zweckmäßigkeit eines Versatzes der Startzeitpunkte gegeneinander, da der zuerst beginnende Flipwinkelverlauf dann bereits auf einen niedrigeren Wert abgefallen sein kann, wenn der zweite Flipwinkelverlauf im Allgemeinen mit hohen Flipwinkelwerten beginnt. Wie das konkrete, hier diskutierte Beispiel zeigt, ist es durchaus denkbar, TRAPS bei einer der aufzunehmenden Schichten nicht anzuwenden und einen Flipwinkelverlauf zu wählen, der konstant 180° nutzt. Die Verwendung eines hiervon abweichenden Flipwinkelverlaufs für die wenigstens eine weitere aufzunehmende Schicht führt jedenfalls zu Unterschieden in den Echozeiten, die entsprechend genutzt werden können.

Der frühere Startzeitpunkt der Refokussierungspulse für wenigstens eine der Schichten bedeutet, dass einige Echos, allerdings solche niedriger Signalintensität, außerhalb des Aufnahmezeitraums zu liegen kommen, mithin in einem Zeitraum ausgegeben werden, in dem die wenigstens eine weitere Schicht noch nicht einmal angeregt wurde. Solche frühen Echos niedriger Intensität können grundsätzlich verworfen werden. In einer vorteilhaften Weiterbildung der Erfindung kann jedoch vorgesehen sein, dass aufgrund der Verschiebung außerhalb des Aufnahmezeitraums liegende Echos zur Messung eines Navigators genutzt werden. Solche Navigatoren werden insbesondere bei Magnetresonanzuntersuchungen eingesetzt, bei denen es zu Bewegungen im Aufnahmebereich des Patienten kommen kann, wobei für derartige Navigatoren auch niedrigere Signalintensitäten ausreichend sind, mithin die frühen Echos zumindest teilweise einer Nutzung zugeführt werden können.

Zweckmäßigerweise können die Flipwinkelverläufe, insbesondere durch eine Steuereinrichtung der Magnetresonanzeinrichtung als Recheneinrichtung, in einem Optimierungsverfahren bestimmt werden, um die manuelle Interaktion mit einem Benutzer möglichst zu reduzieren, der diese grundsätzlich auch zumindest teilweise vorgeben könnte, wozu eine entsprechende Eingabevorrichtung der Magnetresonanzeinrichtung genutzt werden kann. In konkreter Ausgestaltung kann vorgesehen sein, dass die Zielfunktion der Optimierung eine Minimierung der SAR und geringer gewichtet eine hohe Signalintensität bei der Messung beschreibt und/oder als Randbedingungen eine maximale Transmitterspannung für die kombinierten Refokussierungspulse und/oder ein minimaler Flipwinkelwert für jede Schicht und/oder eine maximale Flipwinkeländerungsgeschwindigkeit verwendet werden. Dabei kann grundsätzlich der im Stand der Technik bereits bekannten Vorgehensweise für einen einzigen Flipwinkelverlauf gefolgt werden, wobei nun eine größere Anzahl an zu optimierenden Parametern (Flipwinkeln der Refokussierungspulse) bereitsteht, da zwei Flipwinkelverläufe vorliegen. Als zusätzliche Randbedingung kann eine maximal zulässige Transmitterspannung für die Refokussierungspulse festgelegt werden, mithin die Summe der Flipwinkel unterhalb eines Schwellwerts gehalten werden. Auf diese Weise werden zu hohe Spitzenleistungen vermieden.

Um das Auffinden unterschiedlicher Flipwinkelverläufe durch den in dem Optimierungsverfahren verwendeten Optimierungsalgorithmus zu begünstigen, kann zweckmäßigerweise vorgesehen sein, dass unterschiedliche Initialverläufe als Startwerte für die zu optimierenden Parameter, also für die Flipwinkelverläufe, verwendet werden, insbesondere in Abhängigkeit gewünschter unterschiedlicher Kontraste. Solche Initialverläufe können mithin beispielsweise, insbesondere durchzuführenden Messungen und/oder Kontrasten zugeordnet, in einer Datenbank vorgehalten werden und/oder durch einen Generierungsalgorithmus, beispielsweise einem Generierungsalgorithmus der künstlichen Intelligenz, erzeugt werden. Denkbar ist auch die Erzeugung von Initialverläufen in Abhängigkeit einer Benutzereingabe. Initialverläufe enthalten Startwerte für die zu optimierenden Parameter, hier die Flipwinkel der Refokussierungspulse. Es sei darauf hingewiesen, dass eine weitere Variante zur Herbeiführung unterschiedlicher Winkelverläufe auch eine entsprechende Modifikation der Zielfunktion sein kann, indem beispielsweise auf hohe Signalintensitäten für unterschiedliche Gewebearten abgezielt wird. Beispielsweise kann für eine Schicht auf eine maximale Intensität für ein erstes Gewebe, für eine gleichzeitig aufzunehmende Schicht auf eine maximale Intensität für ein anderes Gewebe optimiert werden.

Neben dem Verfahren betrifft die Erfindung auch eine Magnetresonanzeinrichtung, aufweisend eine zur Durchführung des erfindungsgemäßen Verfahrens ausgebildete Steuereinrichtung. Sämtliche Ausführungen bezüglich des erfindungsgemäßen Verfahrens lassen sich analog auf die erfindungsgemäße Magnetresonanzeinrichtung übertragen, mit welcher mithin ebenso die bereits genannten Vorteile erhalten werden können. Insbesondere kann die Steuereinrichtung mithin eine Flipwinkelverlaufsermittlungseinheit zusätzlich zu bereits bekannten Einheiten, beispielsweise einer Sequenzeinheit zur Durchführung der Aufnahmen, umfassen. Die Steuereinrichtung kann eine Recheneinrichtung sein oder umfassen und entsprechend wenigstens einen Prozessor und/oder wenigstens eine Speichereinrichtung aufweisen.

Ein erfindungsgemäßes Computerprogramm ist beispielsweise direkt in einen Speicher einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen umfasst, welche zumindest ein genanntes Computerprogramm umfassen und derart ausgestaltet sind, das sie bei Verwendung des Datenträgers in einer Steuereinrichtung einer Magnetresonanzeinrichtung das erfindungsgemäße Verfahren durchführen. Bei dem Datenträger kann es sich um einen nichttransienten Datenträger, insbesondere eine CD-ROM, handeln.

Weitere Vorteile und Einzelheiten der vorliegenden Erfindung ergeben sich aus den im Folgenden beschriebenen Ausführungsbeispielen sowie anhand der Zeichnung. Dabei zeigen:
Fig. 1 einen Ablaufplan eines Ausführungsbeispiels des erfindungsgemäßen Verfahrens,
Fig. 2 erste mögliche Flipwinkelverläufe,
Fig. 3 Pulse einer verwendeten Magnetresonanzsequenz in ihrem zeitlichen Ablauf,
Fig. 4 ein Beispiel für einen nicht zur Erfindung gehörenden Flipwinkelverlauf
Fig. 5 dritte mögliche Flipwinkelverläufe,
Fig. 6 vierte mögliche Flipwinkelverläufe, und
Fig. 7 eine Prinzipskizze einer erfindungsgemäßen Magnetresonanzeinrichtung.

Die folgenden Ausführungsbeispiele beziehen sich rein beispielhaft auf die Aufnahme von Magnetresonanzdaten in einem Schichtstapel, wobei der Aufnahmebereich ebenso beispielhaft das menschliche Gehirn ist. Magnetresonanzdaten aus allen Schichten sollen für zwei unterschiedliche Kontraste aufgenommen werden, nämlich mittels einer FLAIR-T2-gewichteten TSE-Sequenz und einer konventionellen T2-gewichteten TSE-Sequenz. Das bedeutet, für einen der Kontraste, hier die FLAIR-Methode, wird ein Präparationspuls (Inversionspuls) benötigt. Vorliegend soll zudem eine Mehrschichtbildgebungstechnik (SMS) mit der gleichzeitigen Aufnahme von zwei Schichten eingesetzt werden, wobei die eine Schicht mit dem ersten Kontrast, die andere Schicht mit dem zweiten Kontrast aufgenommen werden soll. In einem späteren Aufnahmeabschnitt soll dann die umgekehrte Kombination aufgenommen werden, das bedeutet, die erste Schicht mit dem zweiten Kontrast, gleichzeitig die zweite Schicht mit dem ersten Kontrast (vgl. hierzu auch US 2017/0108567 A1). Auf diese Weise wird bezüglich des Präparationspulses die benötigte Spitzenleistung (bestimmt durch die Transmitterspannung für den Präparationspuls) sowie die SAR gering gehalten. Um die SAR für den Patienten auch bezüglich der Refokussierungspulse der TSE-Sequenz als Magnetresonanzsequenz gering zu halten, soll vorliegend die TRAPS-Technik eingesetzt werden, das bedeutet, die Refokussierungspulse der TSE-Sequenz nutzen nicht durchgängig einen Flipwinkel von 180°, sondern folgen einem Flipwinkelverlauf. Im Rahmen der vorliegenden Erfindung ist nun vorgesehen, für die beiden gleichzeitig aufzunehmenden Schichten des Schichtstapels jeweils unterschiedliche Flipwinkelverläufe der TRAPS-Technik einzusetzen, um die SAR für den Patienten weiter zu reduzieren.

Diese Flipwinkelverläufe werden in einem Schritt S1, vorliegend automatisiert bestimmt, indem ein Optimierungsverfahren eingesetzt wird, bei dem die Zielfunktion primär auf die Minimierung der SAR, sekundär auf eine hohe Signalintensität abstellt. Als Randbedingungen wird ein maximal vorliegender Summen-Flipwinkel der Flipwinkelverläufe, mithin eine maximal zu verwendende Transmitterspannung für einen Refokussierungspuls, zudem ein minimaler Flipwinkelwert für jede Schicht und eine maximale Flipwinkeländerungsgeschwindigkeit, vorgegeben. Zweckmäßigerweise werden zudem unterschiedliche Initialverläufe für die Flipwinkelverläufe verwendet, beispielsweise solche, bei denen unterschiedliche Gewebe mit hoher Signalintensität abgebildet werden, vorliegend beispielsweise graue und weiße Gehirnmasse. Selbstverständlich kann die Vorgabe unterschiedliche Initialverläufe auch manuell und/oder anderweitig, beispielsweise unter Verwendung einer entsprechenden Datenbank, erfolgen; unterschiedliche Initialverläufe können auch bei einer zeitlichen Verschiebung des Startzeitpunkts gleicher Grundverläufe entstehen, worauf im Folgenden noch näher eingegangen werden wird.

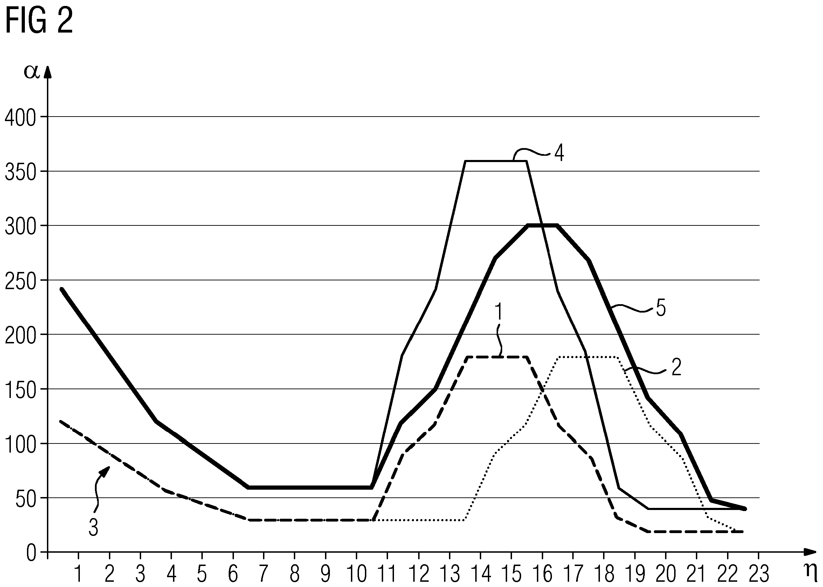

Fig. 2 zeigt ein erstes Beispiel für verwendbare Flipwinkelverläufe 1, 2, wenn die Startzeitpunkte nicht gegeneinander versetzt sind, das bedeutet, die Refokussierungspulse für beide Schichten beginnen zum selben Zeitpunkt innerhalb der Magnetresonanzsequenz. Dabei ist im Graphen der Fig. 2 der im entsprechenden Refokussierungspuls zu verwendende Flipwinkel α gegen die laufende Nummer des Refokussierungspulses n aufgetragen. Der gestrichelte Flipwinkelverlauf 1 ist dabei einem ersten Kontrast, beispielsweise FLAIR, zugeordnet, der gepunktet gezeigte Flipwinkelverlauf 2 dem zweiten Kontrast der Mehrkontrastmessung, vorliegend mithin dem konventionellen T2-Kontrast. Das bedeutet konkret, dass eine Kombination von zwei Schichten zweimal aufgenommen wird, einmal die erste Schicht unter Verwendung des ersten Flipwinkelverlaufs 1, während der Inversionspuls als Präparationspuls auf sie wirkt, und die zweite Schicht mit dem zweiten Flipwinkelverlauf 2, dann die erste Schicht mit dem zweiten Flipwinkelverlauf 2, während der Inversionspuls als Präparationspuls auf die zweite Schicht wirkt, und die zweite Schicht mit dem Flipwinkelverlauf 1. Hierdurch wird für die entstehenden, jeweils einem Kontrast zugeordneten Magnetresonanzdatensätze für die verschiedenen Schichten immer derselbe Kontrast erreicht; subtile Unterschiede der Signalintensität bei Vergleich der beiden Magnetresonanzdatensätze fallen für die Auswertung nicht relevant ins Gewicht. Dies gilt auch bezüglich der weiteren möglichen Flipwinkelverläufe, die hier diskutiert werden.

Wie zu erkennen ist, gehen beide Flipwinkelverläufe 1, 2 der Fig. 2 von einer gleichen Grundform aus, bei der nach einem Präparationsabschnitt 3 mit langsam absinkenden Flipwinkeln ein Plateau bei niedrigen Flipwinkeln erreicht wird, woraufhin der Flipwinkel zeitweise in einer bestimmten Struktur wieder erhöht wird. Hier wird nun der zeitliche Beginn dieser Struktur für beide Flipwinkelverläufe 1, 2 unterschiedlich gewählt, um die auftretenden Spitzenleistungen und mithin die SAR-Belastung für den Patienten niedriger zu halten. Dieser Effekt ist in Fig. 2 durch die durchgehend gezeigten Summenverläufe 4 und 5 illustriert. Der Verlauf 4 ist dabei ein Vergleichsverlauf, der bei der Verwendung gleicher Flipwinkelverläufe für beide Schichten auftreten würde, vorliegend eine Verdopplung des Flipwinkelverlaufs 1. Wie zu erkennen ist, liegt das Maximum der einzelnen Flipwinkelverläufe 1, 2 vorliegend bei 180°, so dass eine sehr hohe Spitzenleistung, entsprechend einem Flipwinkel von 360° für Refokussierungspulse im Bereich dieses Maximums benötigt würde. Durch die Verschiebung der Maximums-Strukturen der Flipwinkelverläufe 1, 2 entsteht jedoch der Summenverlauf 5, der deutlich niedrigere Spitzenleistungen, mithin Transmitterspannungen, und eher eine verteilte, niedrigere SAR-Belastung mit sich bringt.

Nachdem es durch die Verwendung unterschiedlicher Flipwinkelverläufe zu unterschiedlichen zu wählenden Echozeiten TE kommt, beispielsweise einer Echozeit TE1 für einen Flipwinkelverlauf, eine Echozeit TE2 für einen anderen Flipwinkelverlauf, können durch Verschiebung der eigentlichen Anregungspulse gegeneinander zum einen die Enden der Echozeiten TE1, TE2 zu einem bestimmten Zeitpunkt der Magnetresonanzsequenz im Aufnahmezeitraum zusammenfallen, zum anderen wird damit vorteilhaft erreicht, dass auch die Refokussierungspulse für die früher angeregte Schicht zu früheren Zeitpunkten ausgegeben werden, was für eine natürliche Verschiebung der Startzeitpunkte der Gabe der Refokussierungspulse und somit der Flipwinkelverläufe zueinander führt, so dass beispielsweise auch entsprechende Flipwinkelmaxima auf diese Art und Weise gegeneinander verschoben werden können.

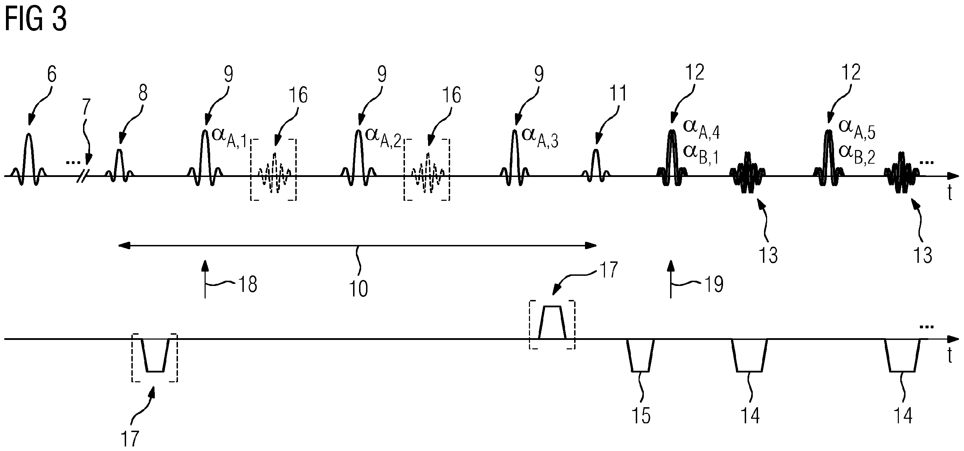

Fig. 3 erläutert dies beispielhaft, indem relevante Anteile der Pulse der verwendeten Magnetresonanzsequenz gezeigt sind. Dabei zeigt der obere Verlauf auszugebende Hochfrequenzpulse und den Empfang von Magnetresonanzsignalen beim Auslesen, mithin Echos, während in dem unteren zeitlichen Verlauf Auslesegradientenpulse dargestellt sind. Selbstverständlich werden, wie grundsätzlich bekannt, auch weitere Gradientenpulse ausgegeben, die hier der Übersichtlichkeit halber nicht gezeigt sind.

Gezeigt ist zunächst in einem deutlichen zeitlichen Abstand zu den späteren Hochfrequenzpulsen der hier als Inversionspuls ausgebildete Präparationspuls 6, der nur auf eine der gleichzeitig aufzunehmenden Schichten wirkt. Nach einer Wartezeit (Inversionszeit), angedeutet durch die Unterbrechung 7, wird dann zunächst der Anregungspuls 8 ausgegeben, der auf die erste Schicht wirkt. Entsprechend beginnen in einem entsprechenden Abstand nach der Gabe des Anregungspulses 8 die Refokussierungspulse 9 für die erste Schicht, die entsprechend auch zunächst nur auf diese Schicht wirken. Erst in einem zeitlichen Abstand 10, der vorliegend dem Unterschied der Echozeiten TE1 - TE2 entspricht, wird dann der Anregungspuls 11 für die zweite Schicht ausgegeben. Entsprechend beziehen sich alle nachfolgenden Refokussierungspulse 12 als Multiband-Refokussierungspulse sowohl auf die erste Schicht als auch auf die zweite Schicht. Entsprechende gemeinsame Echos 13 (Magnetresonanzsignale) werden über entsprechende Auslesegradientenpulse 14 simultan aufgenommen. Bei dem Auslesegradientenpuls 15 handelt es sich um einen Prephaser.

Dabei treten selbstverständlich auch Echos 16 der ersten Schicht nach den nur auf diese Schicht wirkenden Refokussierungspulsen 9 auf, welche jedoch verworfen werden können. Denkbar ist es jedoch auch, wie durch die optional gezeigten Prephaser-Gradientenpulse 17 angedeutet, diese Echos 16 zur Messung eines Navigators zu verwenden, der dann meist als Projektion aufgenommen wird, mithin keinen eigenen Phasenkodiergradientenpuls benötigt.

Wie sich aus Fig. 3 entnehmen lässt, liegt der Startzeitpunkt 18 des Flipwinkelverlaufs für die erste Schicht früher als der Startzeitpunkt 19 des Flipwinkelverlaufs für die zweite Schicht. Dies wird auch durch die entsprechenden neben den Refokussierungspulsen 9, 12 gezeigten Flipwinkel α_{A, i} und α_{B, j} gezeigt, was auch die Unterschiedlichkeit der Flipwinkelverläufe nochmals betont.

Diese zeitliche Verschiebung der Startzeitpunkte 18, 19 kann auf verschiedene Art und Weise genutzt werden. Zum einen kann beispielsweise bereits eine "natürliche" Verschiebung der Maximums-Strukturen beispielsweise der Flipwinkelverläufe 1, 2 der Fig. 2 stattfinden, so dass Maxima nicht länger übereinander liegen. Zum anderen können auch einfachere Flipwinkelverläufe eingesetzt werden, beispielsweise solche, bei denen die größten Flipwinkel im Präparationsbereich 3 der entsprechenden Flipwinkelverläufe auftreten, wobei die Dauer dieser Präparationszeiträume so gewählt ist, dass möglichst die Präparation abgeschlossen ist, bevor der Startzeitpunkt 19 des später beginnenden Flipwinkelbereichs erreicht ist.

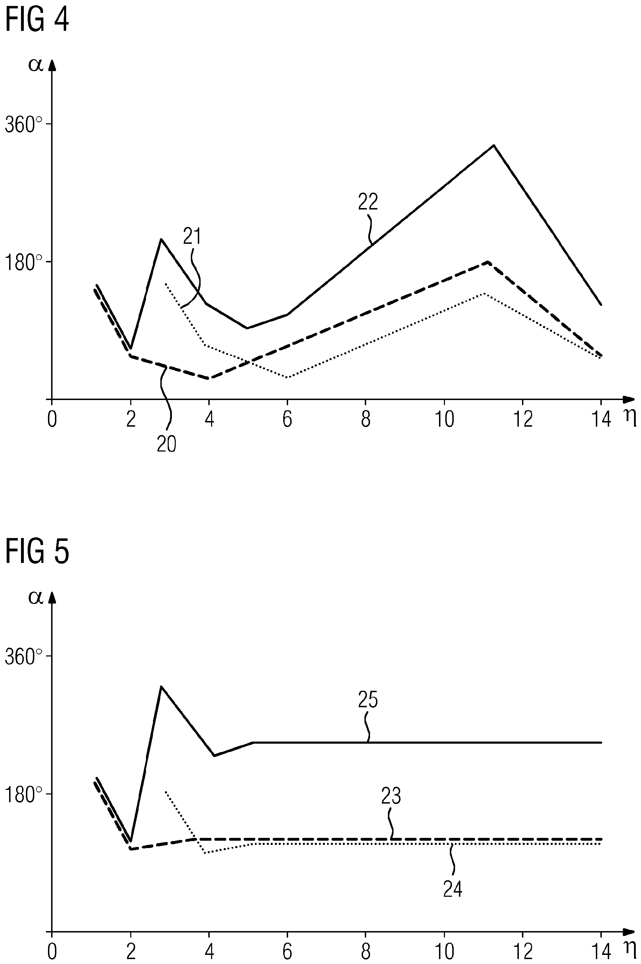

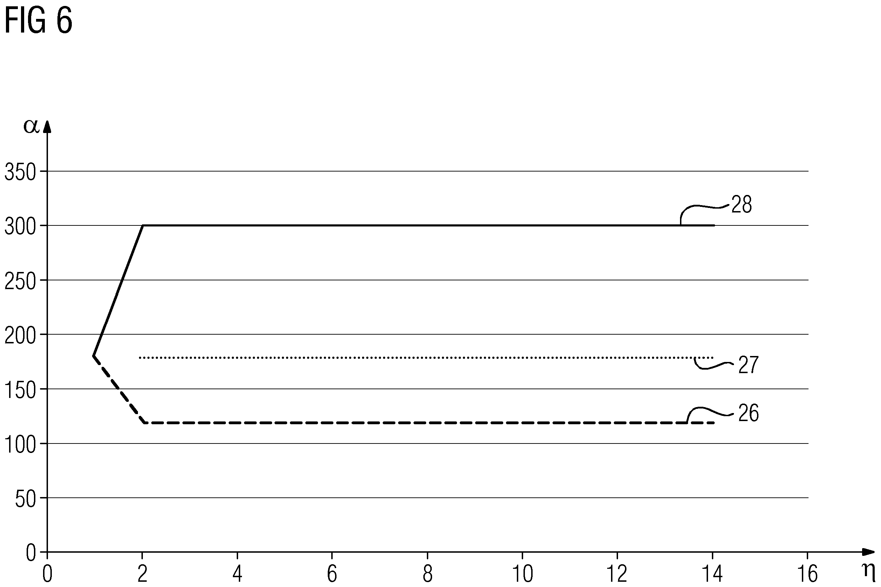

Die Figuren 5 und 6 zeigen weitere Beispiele für mögliche Flipwinkelverläufe.

Im Beispiel der Fig. 4 , das nicht Teil der Erfindung ist, ist wiederum der erste Flipwinkelverlauf 20 gestrichelt gezeigt, der zweite Flipwinkelverlauf 21 gepunktet. Die sich ergebende, die Spitzenpulsspannung beschreibende Summe ist als durchgezogener Summen-Verlauf 22 ebenso gezeigt. Bei den Flipwinkelverläufen 20, 21 treten die höchsten Flipwinkel zu Beginn, also im jeweiligen Präparationsbereich auf, die vorliegend durch den zeitlichen Versatz der Startzeitpunkte 18, 19 voneinander separiert sind. Nachdem im späteren Verlauf niedrigere Flipwinkel genutzt werden, war im vorliegenden Beispiel sogar sinnvoll möglich, die Maxima wieder übereinander zu legen.

Fig. 5 zeigt ein weiteres Beispiel von Flipwinkelverläufen 23, 24, wiederum gestrichelt/gepunktet dargestellt. Beide Flipwinkelverläufe zielen nach der Präparationsphase mit höheren Präparationswinkeln auf einen konstanten, niedrigeren, gleichen Flipwinkel ab. Auch hier zeigt sich am durchgezogen dargestellten Summenverlauf 25 wiederum deutlich, dass durch die zeitliche Trennung der Präparationsphasen 3 besonders hohe Spitzenleistungen/SAR-Belastungen vermieden werden.

Fig. 6 ist schließlich ein Beispiel, bei dem die TRAPS-Methode nur bei einer der Schichten überhaupt angewendet wird, nachdem nur beim ersten Flipwinkelverlauf 26 überhaupt veränderliche Flipwinkel kleiner als 180° auftreten. Der später beginnende, zweite Flipwinkelverlauf 27 (gepunktet) bleibt konstant bei 180°, entspricht also einer nicht-Verwendung der TRAPS-Methode. Durch den späteren Startzeitpunkt 19 des zweiten Flipwinkelverlaufs 27 kann jedoch in der Präparationsphase des ersten Flipwinkelverlaufs 26 problemlos bei 180° begonnen werden, nachdem hierdurch keine Spitzenleistungen forciert werden, wie der durchgezogen dargestellte Summenverlauf 28 zeigt.

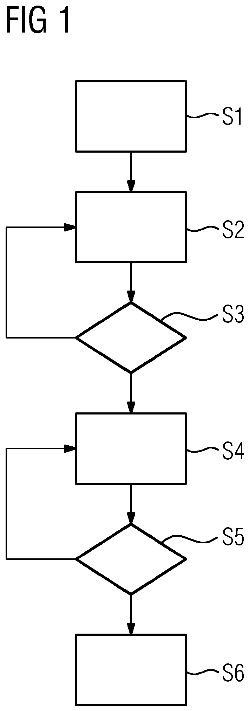

Zurückkehrend zu Fig. 1 beginnt dann in einem Schritt S2 ein erster Durchlauf der Aufnahme von jeweils zwei Schichten des Schichtstapels, wobei jeweils eine der Schichten mit dem ersten Kontrast, die andere mit dem zweiten Kontrast aufgenommen wird, bis, wie durch den Schritt S3 dargestellt, alle Schichten des Schichtstapels einmal aufgenommen wurden.

In einem weiteren Aufnahmeabschnitt, beginnend im Schritt S4, werden dann wiederum Magnetresonanzdaten derselben Kombinationen von Schichten aufgenommen, wobei nun die Kontraste jeweils vertauscht sind, mithin der Präparationspuls 6 auf die Schicht wirkt, auf die er jeweils im ersten Aufnahmeabschnitt (Schritt S2, S3) nicht gewirkt hat. Zudem werden auch die jeweils verwendeten Flipwinkelverläufe vertauscht, nachdem diese einem Kontrast zugeordnet sind. Gemäß Schritt S5 erfolgt auch diese Aufnahme, bis wiederum alle Schichten des Schichtstapels einmal aufgenommen wurden.

Als Ergebnis liegen dann in einem Schritt S6 Magnetresonanzdaten aller Schichten für beide Kontraste vor, wobei die simultane Mehrschichtbildgebungstechnik effektiv eingesetzt wurde. Magnetresonanzdaten unterschiedlicher Schichten aus den gemeinsamen Aufnahmevorgängen können dann, wie üblich, beispielsweise mittels des Schicht-GRAPPA-Algorithmus, im Schritt S6, der allgemein die Weiterverarbeitung zu Magnetresonanzbilddatensätzen symbolisiert, getrennt werden.

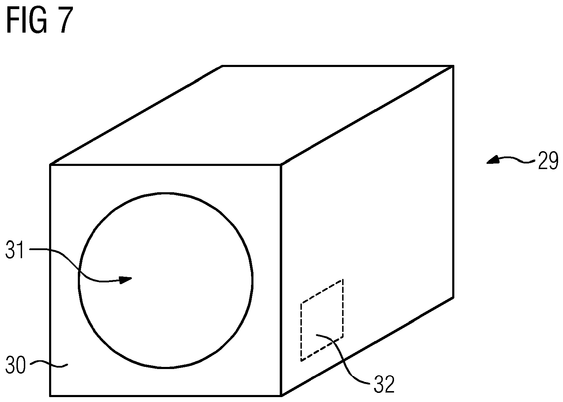

Fig. 7 zeigt schließlich eine Prinzipskizze einer erfindungsgemäßen Magnetresonanzeinrichtung 29. Diese weist, wie grundsätzlich bekannt, eine Hauptmagneteinheit 30 auf, in der eine Patientenaufnahme 31 realisiert ist, in die ein Patient mittels einer hier nicht näher gezeigten Patientenliege eingefahren werden kann. Die Patientenaufnahme 31 umgebend können eine Hochfrequenzspulenanordnung und eine Gradientenspulenanordnung vorgesehen sein.

Der Betrieb der Magnetresonanzeinrichtung 29 wird mittels einer Steuereinrichtung 32 gesteuert, welche entsprechend eine Sequenzeinheit zum Steuern der Aufnahme von Magnetresonanzdaten aufweist, über die entsprechende Pulse koordiniert ausgegeben werden können. Ferner ist eine Flipwinkelverlaufsbestimmungseinheit vorgesehen, die entsprechende unterschiedliche Flipwinkelverläufe, gemäß dem erfindungsgemäßen Verfahren, für unterschiedliche, gleichzeitig aufzunehmende Schichten bei Anwendung einer simultanen Mehrschichtbildgebungstechnik ausgebildet ist.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die beigefügten Ansprüche definiert ist.

## Patentansprüche

1. Verfahren zum Betrieb einer Magnetresonanzeinrichtung (29) bei der Aufnahme von Magnetresonanzdaten eines Patienten mit einer Magnetresonanzsequenz, die nach wenigstens einem Anregungspuls (8, 11) mehrere Hochfrequenz-Refokussierungspulse (9, 12) während eines Auslesezeitraums umfasst, wobei ein zeitlicher Flipwinkelverlauf (1, 2, 20, 21, 23, 24, 26, 27) Vorgabewerte für die Flipwinkel der Refokussierungspulse (9, 12) an Zeitpunkten, zu denen ein Refokussierungspuls (9, 12) ausgegeben werden soll, beschreibt, und wobei die Stärke der Refokussierungspulse (9, 12) einem zeitlichen Flipwinkelverlauf (1, 2, 20, 21, 23, 24, 26, 27) folgt, der die SAR für den Patienten minimierend bestimmt wird, **dadurch gekennzeichnet, dass** eine simultane Mehrschichtbildgebungstechnik zur simultanen Anregung und Auslesung von wenigstens zwei Schichten einer aufzunehmenden Schichtgruppe verwendet wird und, zur weiteren Reduzierung der SAR für den Patienten im Vergleich zu gleichen Flipwinkelverläufen (1, 2, 20, 21, 23, 24, 26, 27) für die wenigstens zwei Schichten, unterschiedliche Flipwinkelverläufe (1, 2, 20, 21, 23, 24, 26, 27) für die wenigstens zwei Schichten derart gewählt werden, dass das Zusammenfallen von Maxima der unterschiedlichen Flipwinkelverläufe (1, 2, 20, 21, 23, 24, 26, 27) vermieden wird.

2. Verfahren nach Anspruch 1, **dadurch gekennzeichnet, dass** als die Magnetresonanzsequenz eine TSE-Sequenz verwendet wird.

3. Verfahren nach einem der vorangehenden Ansprüche, **dadurch gekennzeichnet, dass** für jede aufzunehmende Schicht mehrere unterschiedliche Kontraste aufgenommen werden, wobei bei der Mehrschichtbildgebungstechnik die unterschiedlichen, gleichzeitig zu vermessenden Schichten jeweils mit einem anderen der Kontraste aufgenommen werden und die Kontraste in folgenden Repetitionen derselben Schichten derart permutiert werden, dass jede Schicht mit jedem Kontrast aufgenommen wurde, wobei für jeden Kontrast ein eigener Flipwinkelverlauf (1, 2, 20, 21, 23, 24, 26, 27) bestimmt wird, der für jede Messung mit diesem Kontrast verwendet wird.

4. Verfahren nach Anspruch 3, **dadurch gekennzeichnet, dass** wenigstens einer, jedoch nicht alle, der unterschiedlichen Kontraste durch Ausgabe eines auf die jeweilige Schicht wirkenden Präparationspulses (6) eingestellt wird.

5. Verfahren nach einem der vorangehenden Ansprüche, **dadurch gekennzeichnet, dass** zu unterschiedlichen Echozeiten führende Flipwinkelverläufe (1, 2, 20, 21, 23, 24, 26, 27) verwendet werden, wobei die Anregungspulse (9, 11) und somit die Startzeitpunkte (18, 19) der Flipwinkelverläufe (1, 2, 20, 21, 23, 24, 26, 27) für die unterschiedlichen Schichten zeitlich um ein ganzzahliges Vielfaches der Differenz der Echozeiten versetzt ausgegeben werden, so dass die Echozeiten zum selben Zeitpunkt während der Magnetresonanzsequenz erreicht werden.

6. Verfahren nach Anspruch 5, **dadurch gekennzeichnet, dass** gleiche Grundverläufe für die Flipwinkelverläufe (1, 2, 20, 21, 23, 24, 26, 27) verwendet werden, deren Maxima aufgrund der unterschiedlichen Startzeitpunkte (18, 19) gegeneinander versetzt sind.

7. Verfahren nach Anspruch 5, **dadurch gekennzeichnet, dass** für den Flipwinkelverlauf (1, 2, 20, 21, 23, 24, 26, 27) mit dem späteren Startzeitpunkt (19) ein konstanter erster Flipwinkelwert, insbesondere 180°, gewählt wird, während der Flipwinkelverlauf (1, 2, 20, 21, 23, 24, 26, 27) mit dem früheren Startzeitpunkt (18) von einem Startwert, insbesondere 180°, auf einen insbesondere niedriger als der erste Flipwinkelwert gewählten, zweiten Flipwinkelwert abfällt, insbesondere den zweiten Flipwinkelwert bis zum Startzeitpunkt des zweiten Flipwinkelverlaufs (1, 2, 20, 21, 23, 24, 26, 27) erreichend.

8. Verfahren nach einem der Ansprüche 5 bis 7, **dadurch gekennzeichnet, dass** aufgrund der Verschiebung außerhalb des Aufnahmezeitraums liegende Echos (16) zur Messung eines Navigators genutzt werden.

9. Verfahren nach einem der vorangehenden Ansprüche, **dadurch gekennzeichnet, dass** die Flipwinkelverläufe (1, 2, 20, 21, 23, 24, 26, 27) in einem Optimierungsverfahren bestimmt werden.

10. Verfahren nach Anspruch 9, **dadurch gekennzeichnet, dass** die Zielfunktion der Optimierung eine Minimierung der SAR und geringer gewichtet eine hohe Signalintensität bei der Messung beschreibt und/oder als Randbedingungen eine maximale Transmitterspannung für die kombinierten Refokussierungspulse (9, 12) und/oder ein minimaler Flipwinkelwert für jede Schicht und/oder eine maximale Flipwinkeländerungsgeschwindigkeit verwendet werden.

11. Verfahren nach Anspruch 9 oder 10, **dadurch gekennzeichnet, dass** unterschiedliche Initialverläufe für die Flipwinkelverläufe (1, 2, 20, 21, 23, 24, 26, 27) verwendet werden, insbesondere in Abhängigkeit gewünschter unterschiedlicher Kontraste.

12. Magnetresonanzeinrichtung (29), aufweisend eine zur Durchführung eines Verfahrens nach einem der vorangehenden Ansprüche ausgebildete Steuereinrichtung (32).

13. Computerprogramm, umfassend Befehle, die wenn das Programm auf einer Steuereinrichtung (32) einer Magnetresonanzeinrichtung (29) ausgeführt wird, diese veranlassen, die Schritte eines Verfahrens nach einem der Ansprüche 1-11 durchzuführen.

14. Elektronisch lesbarer Datenträger, auf dem ein Computerprogramm nach Anspruch 13 gespeichert ist.

## Claims

1. Method for operating a magnetic resonance apparatus (29) during the acquisition of magnetic resonance data from a patient using a magnetic resonance sequence, which comprises after at least one excitation pulse (8, 11), a plurality of refocusing pulses (9, 12) during a readout period, wherein a flip-angle variation (1, 2, 20, 21, 23, 24, 26, 27) over time describes setpoint values for the flip angles of the refocusing pulses (9, 12) at time instants at which a refocusing pulse (9, 12) is to be output, and wherein the strength of the refocusing pulses (9, 12) follows a flip-angle variation (1, 2, 20, 21, 23, 24, 26, 27) over time that is defined so as to minimize the SAR for the patient, **characterised in that** a simultaneous multislice imaging technique is used for simultaneous excitation and readout of at least two slices of a slice group to be acquired and, for further reduction of the SAR for the patient compared with the same flip angle variations (1, 2, 20, 21, 23, 24, 26, 27) for the at least two slices, different flip-angle variations (1, 2, 20, 21, 23, 24, 26, 27) for the at least two slices are selected in order to prevent the maxima of the different flip-angle variations (1, 2, 20, 21, 23, 24, 26, 27) from coinciding.

2. Method according to claim 1, **characterised in that** a TSE sequence is used as the magnetic resonance sequence.

3. Method according to one of the preceding claims, **characterised in that** for each slice to be acquired are acquired a plurality of different contrasts, wherein in the multislice imaging technique, the different slices to be measured simultaneously are each acquired using another of the contrasts, and the contrasts are permuted in subsequent repetitions of the same slices such that each slice has been acquired using each contrast, wherein a dedicated flip-angle variation (1, 2, 20, 21, 23, 24, 26, 27) is defined for each contrast and employed for each measurement using this contrast.

4. Method according to claim 3, **characterised in that** at least one, but not all, of the different contrasts is set by outputting a preparation pulse (6) that acts on the slice concerned.

5. Method according to one of the preceding claims, **characterised in that** flip-angle variations (1, 2, 20, 21, 23, 24, 26, 27) leading to different echo times are used, wherein the excitation pulses (9, 11) and hence the start times (18, 19) of the flip-angle variations (1, 2, 20, 21, 23, 24, 26, 27) for the different slices are output at a time offset that equals an integer multiple of the difference in the echo times, so that the echo times are reached at the same point in time during the magnetic resonance sequence.

6. Method according to claim 5, **characterised in that** identical original variations are used for the flip-angle variations (1, 2, 20, 21, 23, 24, 26, 27), the maxima of which are mutually offset because of the different start times (18, 19) .

7. Method according to claim 5, **characterised in that** for the flip-angle variation (1, 2, 20, 21, 23, 24, 26, 27) having the later start time (19), a constant first flip-angle value, in particular 180°, is selected, whereas the flip-angle variation (1, 2, 20, 21, 23, 24, 26, 27) having the earlier start time (18) decreases from an initial value, in particular 180°, to a second flip-angle value, which is chosen in particular to be lower than the first flip-angle value, in particular reaching the second flip-angle value by the start time of the second flip-angle variation (1, 2, 20, 21, 23, 24, 26, 27) .

8. Method according to one of claims 5 to 7, **characterised in that** echoes (16) lying outside the acquisition period as a result of the offset are used for measuring a navigator.

9. Method according to one of the preceding claims, **characterised in that** the flip-angle variations (1, 2, 20, 21, 23, 24, 26, 27) are determined in an optimisation process.

10. Method according to claim 9, **characterised in that** the objective function of the optimisation specifies minimising the SAR and, with lower weighting, a high signal intensity in the measurement, and/or that a maximum transmitter voltage for the combined refocusing pulses (9, 12) and/or a minimum flip-angle value for each slice and/or a maximum rate of change of flip angle are used as boundary conditions.

11. Method according to claim 9 or claim 10, **characterised in that** different initial variations are used for the flip-angle variations (1, 2, 20, 21, 23, 24, 26, 27), in particular depending on desired different contrasts.

12. Magnetic resonance apparatus (29) having a controller (32) designed to implement a method according to one of the preceding claims.

13. Computer programme, comprising commands which, if the programme is executed on a controller (32) of a magnetic resonance device (29), triggers this to perform the steps of a method according to one of claims 1 to 11.

14. Electronically readable data storage medium, on which is stored a computer programme according to claim 13.

## Revendications

1. Procédé pour faire fonctionner un dispositif (29) de résonnance magnétique lors de l'enregistrement de données de résonnance magnétique d'un patient par une séquence de résonnance magnétique qui, après au moins une impulsion (8, 11) d'excitation, comprend plusieurs impulsions (9, 12) de refocalisation de haute fréquence pendant un laps de temps de lecture, dans lequel une courbe (1, 2, 20, 21, 23, 24, 26, 27) d'angle de flip en fonction du temps décrit des valeurs de prescription de l'angle de flip des impulsions (9, 12) de refocalisation à des instants où une impulsion (9, 12) de refocalisation doit être émise et dans lequel l'intensité des impulsions (9, 12) de refocalisation suit une courbe (1, 2, 20, 21, 23, 24, 26, 27) d'angle de flip en fonction du temps qui est déterminée en minimisant la SAR du patient, **caractérisé en ce que** l'on utilise une technique d'imagerie simultanée à plusieurs couches pour exciter et lire simultanément au moins deux couches d'un groupe de couches à enregistrer et pour réduire davantage la SAR du patient en comparaison des mêmes courbes (1, 2, 20, 21, 23, 24, 26, 27) d'angle de flip pour les au moins deux couches, des courbes (1, 2, 20, 21, 23, 24, 26, 27) d'angle de flip différentes pour les au moins deux couches, de manière à empêcher la coïncidence de maximums des courbes (1, 2, 20, 21, 23, 24, 26, 27) d'angle de flip différentes.

2. Procédé suivant la revendication 1, **caractérisé en ce que** l'on utilise une séquence TSE comme séquence de résonnance magnétique.

3. Procédé suivant l'une des revendications précédentes, **caractérisé en ce qu'**on enregistre plusieurs contrastes différents pour chaque couche à enregistrer, dans lequel, dans la technique d'imagerie à plusieurs couches, on enregistre les couches différentes à mesurer en même temps, respectivement avec un autre des contrastes et on permute les contrastes dans des répétitions suivantes des mêmes couches de manière à ce que chaque couche ait été enregistrée avec chaque contraste dans lequel on détermine pour chaque contraste une courbe (1, 2, 20, 21, 23, 24, 26, 27) d'angle de flip propre, que l'on utilise pour chaque mesure avec ce contraste.

4. Procédé suivant la revendication 3, **caractérisé en ce que** l'on règle au moins l'un, mais pas tous les contrastes différents, par émission d'une impulsion (6) de préparation agissant sur la couche respective.

5. Procédé suivant l'une des revendications précédentes, **caractérisé en ce que** l'on utilise des courbes (1, 2, 20, 21, 23, 24, 26, 27) d'angle de flip donnant des temps d'écho différents, les impulsions (9, 11) d'excitation et ainsi les instants (18, 19) de début des courbes (1, 2, 20, 21, 23, 24, 26, 27) d'angle de flip étant émises dans le temps d'une manière décalée d'un multiple en nombre entier de la différence des temps d'écho pour les couches différentes, de manière à atteindre les temps d'écho au même instant pendant la séquence de résonnance magnétique.

6. Procédé suivant la revendication 5, **caractérisé en ce que** l'on utilise deux mêmes courbes de base pour les courbes (1, 2, 20, 21, 23, 24, 26, 27) d'angle de flip, dont les maximums sont décalés mutuellement en raison des instants (18, 19) de début différents.

7. Procédé suivant la revendication 5, **caractérisé en ce que** l'on choisit pour la courbe (1, 2, 20, 21, 23, 24, 26, 27) d'angle de flip, ayant l'instant (19) de début plus tardif, une première valeur d'angle de flip constante, notamment de 180°, tandis que la courbe (1, 2, 20, 21, 23, 24, 26, 27) d'angle de flip ayant l'instant (18) de début plus tôt passe d'une valeur de début, notamment de 180°, à une deuxième valeur d'angle choisie notamment plus petite que la première valeur d'angle de flip, en atteignant notamment la deuxième valeur d'angle de flip à l'instant de début de la deuxième courbe (1, 2, 20, 21, 23, 24, 26, 27) d'angle de flip.

8. Procédé suivant l'une des revendications 5 à 7, **caractérisé en ce que** l'on utilise pour la mesure d'un navigateur des échos (19) se trouvant à l'extérieur du laps de temps d'enregistrement en raison du décalage.

9. Procédé suivant l'une des revendications précédentes, **caractérisé en ce que** l'on détermine dans un procédé d'optimisation les courbes (1, 2, 20, 21, 23, 24, 26, 27) d'angle de flip.

10. Procédé suivant la revendication 9, **caractérisé en ce que** la fonction cible de l'optimisation décrit une minimisation de la SAR et, un peu pondérée, une grande intensité du signal lors de la mesure et/ou on utilise, comme condition aux limites, une tension d'émetteur maximum pour les impulsions (9, 12) de refocalisation combinées et/ou une valeur d'angle de flip minimum pour chaque couche et/ou une vitesse de variation d'angle de flip maximum.

11. Procédé suivant la revendication 9 ou 10, **caractérisé en ce que** l'on utilise des courbes initiales différentes pour les courbes (1, 2, 20, 21, 23, 24, 26, 27) d'angle de flip, notamment en fonction de contrastes différents souhaités.

12. Dispositif (29) de résonnance magnétique, comportant un dispositif (32) de commande constitué pour effectuer un procédé suivant l'une des revendications précédentes.

13. Programme d'ordinateur, comprenant des instructions qui, lorsque le programme est réalisé sur un dispositif (32) de commande d'un dispositif (29) de résonnance magnétique, fait que celui-ci effectue les stades d'un procédé suivant l'une des revendications 1 à 11.

14. Support de données déchiffrables électroniquement, sur lequel est mis en mémoire un programme d'ordinateur suivant la revendication 13.
